# FASCICULE DE BREVET EUROPEEN

(11) **EP 0 996 228 B1**
(45) Date de publication et mention de la délivrance du brevet: **06.04.2005**
(21) Numéro de dépôt: 99402382.8
(22) Date de dépôt: 30.09.1999
(51) Int. Cl.: H03K 17/96

(54) **Contacteur à touche sensitive**
Berührungsempfindliche Tastschalter
Touch sensitive switch

(30) Priorité: 22.10.1998 FR 9813239
(43) Date de publication de la demande: 26.04.2000
(73) Titulaire: Amphitech Société à responsabilité limitée, 75011 Paris (FR)
(72) Inventeur: Wehrbach, Alain Paul René, 94370 Sucy en Brie (FR)
(74) Mandataire: Vander-Heym, Serge

(56) Documents cités:
- EP-A- 0 341 576
- EP-A- 0 478 856

## Description

La présente invention est relative à une touche de commande du genre de celles permettant, à l'aide d'une action manuelle, de modifier l'état d'un circuit électrique et dénommée, ci-après « contacteur ».

Ces touches sont de deux types à savoir : la touche mécanique et la touche sensitive. Dans le premier cas, une action mécanique, telle que l'enfoncement d'un bouton-poussoir, commande, par exemple, la fermeture d'un contact électrique, dans le second cas, la présence du doigt de l'opérateur, qui perturbe l'accord d'un oscillateur, est détectée et le signal résultant est appliqué à un relais qui ferme un circuit électrique.

Dans les deux cas, on voit donc qu'une action humaine permet d'effectuer une action électrique par l'entremise d'une interface qui constitue une entité physique dénommée ci-après contacteur.

En l'état actuel de la technique, à chaque mode d'exploitation correspond un contacteur différent selon l'effet attendu sur le circuit électrique (fermeture instantanée du circuit, retardée, temporisée, etc.).

Cette obligation pose, naturellement, d'importants problèmes de stockage aux constructeurs.

Un autre problème consiste à détecter une panne sur le contacteur, que celle-ci résulte d'une usure normale ou, comme c'est le cas le plus souvent d'un acte de malveillance (destruction, blocage, etc.). Actuellement, une telle panne ne peut être détectée que par la présence d'un technicien sur le site.

Le but de l'invention est la réalisation d'un contacteur qui puisse remédier aux problèmes évoqués ci-dessus.

De la façon connue, par le document EP 0 478 856; le contacteur comporte un oscillateur, accordée sur une fréquence de repos, présentant un condensateur plan, ladite fréquence étant perturbée par la présence du doigt de l'utilisateur à proximité dudit condensateur résultant de la présence de l'utilisateur étant appliquée à un microprocesseur programmable qui actionne un relais.

Dès lors on comprend que par une programmation judicieuse, effectuée en usine, le même contacteur pourra avoir des fonctions différentes.

Selon l'invention, le condensateur présente une troisième électrode permettant d'injecter dans l'oscillateur, à partir du microprocesseur, une fréquence, ou fréquence test, distincte de celle de veille ou de celle résultant d'une action humaine.

Le microprocesseur, ou MP, est programmé pour envoyer la fréquence test périodiquement. Lorsque l'oscillateur est contrarié par la fréquence test, il s'accorde sur cette fréquence et il adresse un signal correspondant au MP qui compare ce signal à la valeur stockée dans sa mémoire. Si le MP constate une différence entre le signal émis et celui reçu il émet alors un signal qui peut être utilisé pour commander une alarme.

L'invention sera mieux comprise par la description qui va suivre faite en se référant au dessin annexé à titre d'exemple indicatif seulement, sur lequel :
- la figure 1 est une vue synoptique d'un contacteur sans troisième électrode;
- la figure 2 est une vue, analogue à la figure 1, montrant une réalisation de l'invention.

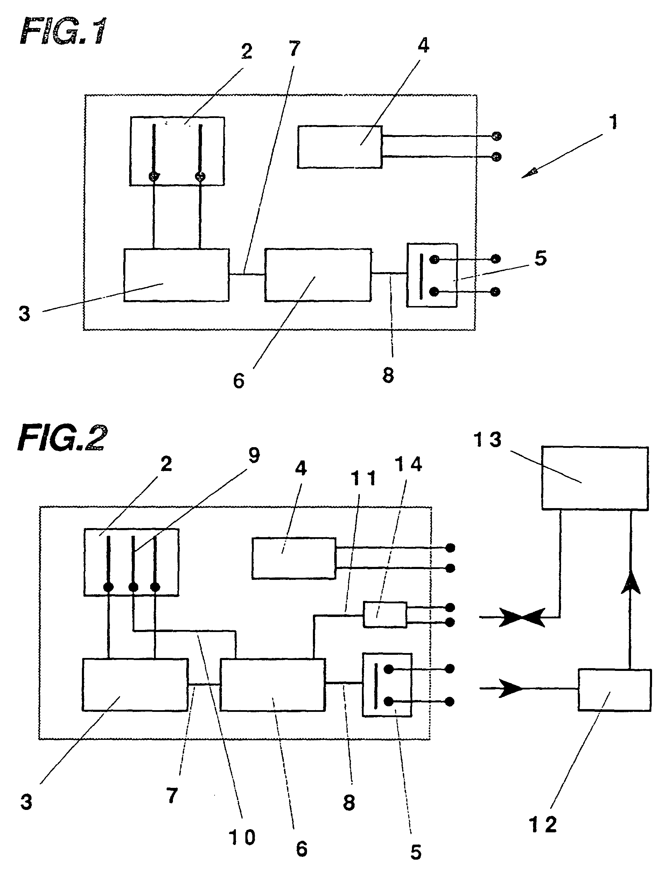

En se reportant à la figure 1 on voit que le contacteur 1 comporte les éléments suivants : un condensateur 2, dont les deux armatures forment l'organe sensible, un amplificateur opérationnel 3, formant avec le condensateur 2 un oscillateur, une alimentation schématisée en 4, un relais 5 et un microprocesseur 6, ou MP.

L'oscillateur 2-3 est accordé sur une fréquence de l'ordre, par exemple, de 10 kilohertz, ou fréquence de veille. Lorsqu'une personne approche son doigt du condensateur 2, la fréquence de veille est contrariée par l'effet d'absorption du champ électromagnétique causé par l'action humaine et l'oscillateur s'accorde sur une nouvelle fréquence qui est de 50 hertz, ou fréquence de commande. Ce phénomène est connu.

L'oscillateur transmet, par la liaison 7, la fréquence au MP 6 qui compare le signal reçu aux valeurs stockées dans la mémoire du MP. Si le MP constate la présence de la fréquence de commande il envoie un signal, par la liaison 8, qui a pour effet d'actionner le relais 5. Dès lors, on comprend que, selon la configuration du MP, effectué par le fabricant, l'action humaine aura un effet immédiat sur le relais ou, par exemple une action retardée, voire temporisée.

Il ressort des explications ci-dessus qu'un contacteur, bien que constitué à partir des mêmes composants, pourra remplir des fonctions très différentes.

Dans le cas d'un contacteur classique à bouton-poussoir utilisé, par exemple, dans une cabine d'ascenseur, si par une manoeuvre intempestive, voire malveillante, on bloque le poussoir, la commande de la cabine n'est plus possible et il n'est pas possible en l'état de la technique de déceler cette panne de façon à faire intervenir, sans tarder, un technicien. C'est l'usager qui, à ses dépends, constatera sur place le défaut et avertira le service de maintenance. En d'autres termes, il n'existe pas sur le marché de contacteurs capables de transmettre un message du type « je ne fonctionne pas ».

L'invention a pour but de déceler un mauvais fonctionnement du contacteur.

Le contacteur de l'invention est remarquable en ce que le condensateur 2 présente une troisième électrode 9 à laquelle le MP 6 transmet, à travers la liaison 10, une fréquence de test distincte de celle de veille et de commande. Cette fréquence peut être de l'ordre de 1 kilohertz.

Cette fréquence permet de simuler une action sur le condensateur 2. Si le contacteur est en état de fonctionnement, le MP reçoit par la liaison 7, la fréquence de test et rien ne se passe. Dans le cas contraire, le MP émet un signal, en 11 ou « sortie défaut », qui peut être utilisé pour commander une alarme. Dans sa forme la plus simple, cette alarme peut être constituée par une source lumineuse (une LED par exemple, non représentée), intégrée au contacteur ou située dans un local de surveillance. On peut aussi concevoir l'utilisation de deux LED, une rouge et une verte, la verte étant allumée si le contacteur est en bon état et la rouge dans le cas contraire. En cas d'une rupture d'alimentation ou de défaillance du MP, les deux LED sont éteintes. Il est possible, ainsi, de déterminer la nature du défaut.

Le contacteur de l'invention se prête à une surveillance à distance de l'ensemble d'une installation.

Ainsi, pour fixer les idées, prenons le cas d'une cabine d'ascenseur. Dans ce type d'installation, on sait qu'une action sur la « touche 6 » constituée dans le cas présent par un contacteur conforme à celui de la figure 2, a pour effet de transmettre une information, par le relais 5, à une centrale de contrôle 12 qui commande la fermeture des portes, actionne le moteur pour envoyer la cabine au sixième étage, constate l'arrivée de la cabine à cet étage et ouvre les portes.

Dans le cas d'une surveillance à distance de l'installation, le point d'alarme « sortie défaut», schématisé en 11, est relié à l'ordinateur de la centrale de télésurveillance 13, avec interposition d'une liaison série au format informatique, schématisé en 14, permettant audit ordinateur d'échanger des informations avec le MP correspondant.

Le contrôle du contacteur s'effectue de la même façon que décrit précédemment étant fait observer que l'envoi de la fréquence de test peut être commandé à partir de la centrale de télésurveillance. Le MP peut être programmé pour confirmer la réception des instructions reçues.

La centrale de télésurveillance peut adresser au MP un ordre pour actionner le relais 5 afin d'envoyer la cabine à l'étage correspondant au contacteur testé. Si l'installation est bonne, la centrale de contrôle envoie, à la centrale de télésurveillance, un signal confirmant l'arrivée de la cabine à l'étage désiré.

A travers l'exemple ci-dessus, il ressort que le contacteur de l'invention permet la mise en oeuvre de moyens permettant d'effectuer un contrôle complet d'une installation, partie électrique et partie mécanique.

## Revendications

1. Contacteur comportant, d'une part, une touche sensitive, constituée par un condensateur (2) incorporé à un oscillateur accordé sur une fréquence de veille, dont la fréquence peut être perturbée par une présence humaine, et, d'autre part un microprocesseur (6) et une alimentation (4), le microprocesseur (6) étant susceptible de commander un relais (5) selon des conditions déterminées, à l'avance, par une programmation judicieuse dudit microprocesseur, **caractérisé en ce que** le condensateur (2) présente une troisième électrode (9) à laquelle le microprocesseur peut envoyer une fréquence de test, distincte de celle de commande et de celle de veille, la fréquence de l'oscillateur résultant de cette fréquence de test étant appliquée au microprocesseur qui, s'il constate une différence entre la fréquence émise et celle reçue, délivre un signal qui est utilisé pour commander une alarme.

2. Contacteur selon la revendication 1, **caractérisé en ce que** le microprocesseur peut être relié, par une liaison sortie défaut et avec interposition d'une liaison série au format informatique (14), à l'ordinateur d'une centrale de télésurveillance (13).

## Patentansprüche

1. Einschalter mit einerseits einer durch einen in einen auf eine Standby-Frequenz abgestimmten Oszillator integrierten Kondensator (2) gebildeten sensitiven Taste und dessen Frequenz durch eine menschliche Anwesenheit gestört werden kann, und andererseits einen Mikroprozessor (6) und eine Versorgung (4), wobei der Mikroprozessor (6) zur Steuerung eines Relais (5) gemäß zuvor durch eine sinnvolle Programmierung des genannten Mikroprozessors bestimmten Bedingungen geeignet ist, **dadurch gekennzeichnet, dass** der Kondensator (2) eine dritte Elektrode (9) aufweist, an die der Mikroprozessor eine von der der Steuerung und des Standby unterschiedliche Testfrequenz senden kann, wobei die Frequenz des Oszillators aus dieser auf den Mikroprozessor angewendeten Testfrequenz resultiert, welcher, wenn er eine Abweichung zwischen der ausgegebenen Frequenz und der empfangenen Frequenz feststellt, ein Signal ausgibt, das zur Steuerung eines Alarms genutzt wird.

2. Einschalter gemäß Anspruch 1, **dadurch gekennzeichnet, dass** der Mikroprozessor durch einen Ausfall-Ausgangs-Anschluss und mit Zwischenschaltung eines seriellen Anschlusses im IT-Format (14) an den Computer einer Fernüberwachungszentrale (13) angeschlossen sein kann.

## Claims

1. A contactor which includes, firstly, a sensitive element composed of a capacitor (2) incorporated into an oscillator, tuned to a standby frequency, this frequency being altered by a human presence, and secondly, a microprocessor (6) and a power source (4), where the microprocessor (6) is able to control a relay (5) under conditions which are determined in advance by suitable programming of the said microprocessor, **characterised in that** the capacitor (2) has a third electrode (9) to which the microprocessor is able to send a test frequency that is different from that used for control and that used for standby, where the frequency of the oscillator resulting from this test frequency is then applied to the microprocessor which, if it detects a difference between the frequency emitted and that received, delivers a signal which is used to operate an alarm.

2. A contactor in accordance with claim 1, **characterised in that** the microprocessor can be connected via an output fault link, with the interposition of a computer type serial link (14), to the computer of a remote surveillance centre (13).
